# EUROPEAN PATENT APPLICATION

(11) **EP 1 107 451 A2**
(43) Date of publication of application: **13.06.2001**
(21) Application number: 00309997.5
(22) Date of filing: 10.11.2000
(51) Int. Cl.: H03G 7/00, H03G 1/00

(54) **Transmission path switching circuit**

(30) Priority: 01.12.1999 JP 34168099
(71) Applicant: ALPS ELECTRIC CO., LTD., Ota-ku Tokyo 145 (JP)
(72) Inventor: Yamamoto, Masaki, c/o Alps Electric Co., Ltd., Tokyo 145 (JP)
(74) Representative: Kensett, John Hinton

(57) **Abstract**

Even if the range of an input signal level is wide, the level range of a signal to be outputted will be narrowed to thereby facilitate improvement of distortion and NF. A transmission path switching circuit according to the present invention is provided with an amplifier (3), and a by-pass circuit (21), and is constructed so as to switch the gain in the amplifier between two stages. When the level of an input signal inputted to an input end is within the first level range being equal to, or higher than the first predetermined level, the input signal is outputted to an output end through the by-pass circuit. When the level of the input signal is within a second level range being equal to or lower than the first predetermined level and equal to or higher than a second predetermined level, the gain of the amplifier is set to first gain. When the input signal is within a third level range being equal to or lower than the second predetermined level, the gain of the amplifier is set to second gain being higher than the first gain.

## Description

### BACKGROUND OF THE INVENTION

### [Detailed Description of the Invention]

### [Technical Field of the Invention]

The present invention relates to a transmission path switching circuit to be used for a television tuner and the like.

### [Description of the Prior Art]

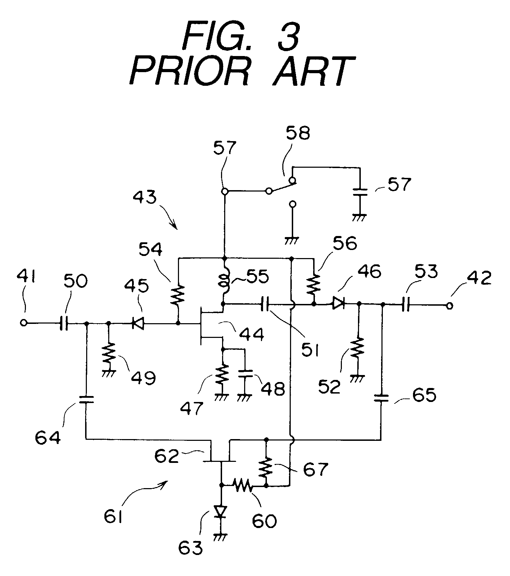

Fig. 3 shows a conventional transmission path switching circuit, and an amplifier 43 and a by-pass circuit 61 are provided side by side between an input end 41 and an output end 42. The amplifier 43 has a first FET 44 as an amplification element and two switching diodes 45 and 46. A source for the first FET 44 is grounded through source bias resistance 47 and a by-pass capacitor 48.

An anode of the first switching diode 45 is connected to a gate of the first FET 44, and a cathode is grounded through bias resistance 49, and is connected to the input end 41 through a DC cut capacitor 50. An anode of the second switching diode 46 is connected to a drain of the first FET 44 through a DC cut capacitor 51, and a cathode is grounded through bias resistance 52, and is connected to an output end 42 through a DC cut capacitor 53.

A node between the anode of the first switching diode 45 and the gate of the first FET 44, a drain of the first FET 44, and the anode of the second switching diode 46 are connected to a voltage applying terminal 57 through feeding resistance 54, a choke inductor 55 and feeding resistance 56 respectively.

On the other hand, the bias circuit 61 has a second FET 62 and a diode 63 for voltage drop, and a drain of the second FET 62 is connected to the cathode of the first switching diode 45 through a DC cut capacitor 64, and its source is connected to a cathode of the second switching diode 46 through a DC cut capacitor 65.

An anode of the diode 63 is connected to the gate of the second FET 62, and its cathode is grounded. The gate and source are connected to the voltage applying terminal 57 through feeding resistance 66 and 67 respectively.

Voltage from power supply 59 is applied to the voltage applying terminal 57 by a change-over switch 58. The change-over switch 58 is constructed of, for example, a switching circuit, and is controlled such that the voltage applying terminal 57 is connected to the power supply 59 when a signal (input signal) to be inputted to the input end 41 exceeds a predetermined level, and that it is grounded when the input signal is equal to or lower than the predetermined level.

The voltage at the power supply 59 is somewhat higher voltage (for example, 5 volt) than a sum of pinch off voltage (about 4 volt) of the second FET 62 and forward voltage (about 0.7 volt) of the diode 63.

In the above described structure, in the case where the level of the input signal is equal to or lower than a predetermined level, when voltage from the power supply 59 is applied to the voltage applying terminal 57, the first and second switching diodes 45 and 56 are first turned on, and bias voltage is applied to the gate of the first FET 44 through resistance 49 and 54 at both ends of the first switching diode 45 to cause the first FET 44 to enter an operating state.

On the other hand, the source voltage of the second FET 62 becomes equal to the voltage of the power supply 59, and the gate voltage becomes equal to the forward voltage (about 0.7 volt) of the diode 63. As a result, the gate voltage of the second FET 62 becomes equal to or lower than the pinch off voltage with respect to the source voltage to cause connection between drain and source of the second FET 62 to be cut off (off-state) .

Accordingly, the input signal does not pass through the by-pass circuit 61, but is amplified by the amplifier 43 to be outputted to the output end 42.

When the level of the input signal exceeds the predetermined level, the first and second switching diodes 45 and 46 are turned off, and no bias voltage is applied to the gate of the first FET 44 because the voltage applying terminal 57 is grounded.

On the other hand, since the gate and source of the second FET 62 are at the same potential, the gate exceeds the pinch-off voltage to cause the connection between drain and source to be in conduction.

As a result, the input signal by-passes the amplifier 43, and is outputted at the output end 42 via the by-pass circuit 61.

Therefore, when it is lower than the predetermined level, the input signal can be amplified by the amplifier 43 for outputting, and when it is higher than the predetermined level, the input signal can be outputted via the by-pass circuit 61. Therefore, it is possible to keep a level range of a signal to be outputted within a certain fixed range.

### [Problems to be solved by the Invention]

In the above described conventional transmission path switching circuit, however, switching has been made only between two stages: amplifying the input signal to output and outputting as it is without amplifying, and therefore, if the level range of the input signal is wide, the level range of a signal to be outputted will also correspond to it to become wider so that it has become difficult to keep distortion, which occurs in a mixer or the like to be connected in the latter stage, and entire NF within a predetermined standard over the entire level range for the input signal.

### SUMMARY OF THE INVENTION

Thus, it is an object of the present invention to easily improve distortion and NF by reducing, even if the level range of the input signal is wide, the level range of a signal to be outputted.

### [Means for solving the Problems]

In order to solve the above described problems, in a transmission path switching circuit according to the present invention are provided with an amplifier disposed between an input end and an output end, and a by-pass circuit disposed between the input end and the output end, and constructed so as to switch gain in the amplifier between two stages, wherein when the level of an input signal inputted to the input end is within a first level range being equal to or higher than a first predetermined level, the input signal is not amplified but is outputted to the output end through the by-pass circuit; wherein when the level of the input signal is lower than the first predetermined level, the input signal is amplified by the amplifier to output to the output end; when the level of the input signal is within a second level range between the first predetermined level and a second predetermined level being lower than the first predetermined level, gain of the amplifier is set to first gain; and wherein when the input signal is within a third level range being equal to or lower than the second predetermined level, the gain of the amplifier is set to second gain being higher than the first gain.

Preferably, in a transmission path switching circuit according to the present invention, the amplifier has the first FET, a first switching diode disposed in series between the input end and the gate of the first FET, and a second switching diode disposed in series between a drain of the first FET end and the output end, and the by-pass circuit has a second FET, to whose input end one of drain and source is connected, and to whose output end the other is connected; when the level of the input signal is within the first level range, the first and second switching diodes are turned off, and the gate voltage of the second FET is made higher than the pitch off voltage of the second FET; when the level of the input signal is within the second level range, the gate voltage of the second FET is made lower than the pinch off voltage, the first and second switching diodes are turned on, and the first bias voltage is applied to the gate of the first FET; and when the input signal is within the third level range, the gate voltage of the second FET is made lower than the pinch off voltage, the first and second switching diodes are turned on, and second bias voltage being higher than the first bias voltage, is applied to the gate of the first FET.

Advantageously, according to the present invention, in the transmission path switching circuit are provided with: a first terminal for applying voltage to the anode of the first switching diode, the gate of the first FET, and the anode of the second switching diode; a second terminal for applying voltage to the gate and source of the second FET through feeding resistance respectively; and a diode for voltage drop, whose anode is connected to the gate of the second FET, and whose cathode is grounded, wherein when the level of the input signal is within the first level range, no voltage is applied to the first terminal and the second terminal, but both terminals are caused to be in a released state; wherein when the level of the input signal is within the second level range, the first voltage is applied to the first terminal, and second voltage, which becomes equal to, or higher than a sum of forward voltage of the diode for voltage drop and the pinch off voltage, is applied to the second terminal; and wherein when the level of the input signal is within the third level range, third voltage being higher than the first voltage, is applied to the first terminal, and the second voltage is applied to the second terminal.

Preferably, the anode of the first switching diode is connected to the gate of the first FET in a DC way, and the cathode thereof is grounded through the first bias resistance, the cathode of the second switching diode is grounded through the second bias resistance; wherein the anode of the first switching diode is connected to the first terminal through the first feeding resistance; and wherein the anode of the second switching diode is connected to the first terminal through the second feeding resistance.

Preferably, the first terminal is grounded through first resistance for divided voltage, second resistance for divided voltage is connected between the first terminal and the second terminal, the third voltage is made equal to the second voltage; wherein values for the first and second resistance are set such that divided voltage at the first terminal when the second voltage is applied to the second terminal becomes equal to the first voltage; wherein when the level of the input signal is within the second level range, the second voltage is applied only to the second terminal; and wherein when the level of the input signal is within the third level range, the second voltage is applied to the first terminal and the second terminal.

### BRIEF DESCRIPTION OF THE DRAWINGS

Fig. 1 is a circuit diagram showing structure of a transmission path switching circuit according to the present invention;
Fig. 2 is a characteristic diagram showing relationship between an input signal level and an output signal level in a transmission path switching circuit according to the present invention; and
Fig. 3 is a circuit diagram showing the structure of a transmission path switching circuit according to the prior art.

### DETAILED DESCRIPTION OF THE PREFERRED EMBODIMENTS

### [Embodiments of the Invention]

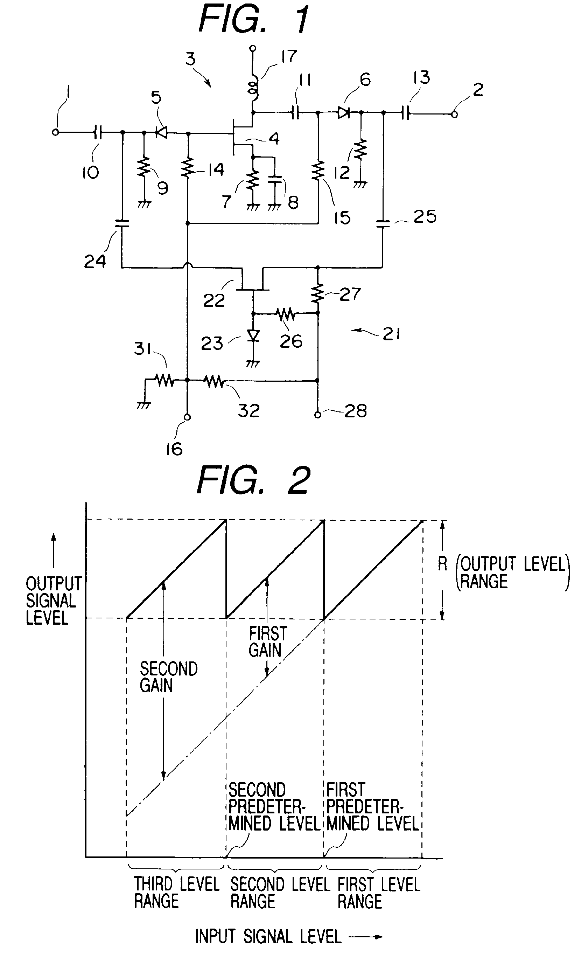

Fig. 1 shows a transmission path switching circuit according to the present invention, and an amplifier 3 and a by-pass circuit 21 are provided side by side between an input end 1 and an output end 2. The amplifier 3 has a first FET 4 as an amplification element and two switching diodes 5 and 6. A source of the first FET 4 is grounded through source bias resistance 7 and a by-pass capacitor 8.

An anode of the first switching diode 5 is directly connected to a gate of the first FET 4, and a cathode is grounded through first bias resistance 9, and is connected to the input end 1 through a DC cut capacitor 10. An anode of the second switching diode 6 is connected to a drain of the first FET 4 through a DC cut capacitor 11, and a cathode is grounded through second bias resistance 12, and is connected to an output end 2 through a DC cut capacitor 13.

A node between the anode of the first switching diode 5 and the gate of the first FET 4, and the anode of the second switching diode 6 are connected to the first terminal 16 through first feeding resistance 14 and second feeding resistance 15 respectively.

Also, supply voltage is supplied to the drain through a choke inductor 17.

On the other hand, the bias circuit 21 has a second FET 22 and a diode 23 for voltage drop, and either a drain or a source of the second FET 22 is connected to a node between the cathode of the first switching diode 5 and the DC cut capacitor 10 through a DC cut capacitor 24, and the other is connected to a node between the cathode of the second switching diode 6 and a DC cut capacitor 13 through a DC cut capacitor 25.

The anode of the diode 23 is connected to the gate of the second FET 22, and its cathode is grounded. The gate and the source are connected to a second terminal 28 through third feeding resistance 26 and fourth feeding resistance 27 respectively.

Further, first resistance for divided voltage 31 is connected between the first terminal 16 and ground, and second resistance for divided voltage 32 is connected between the first terminal 16 and the second terminal 28.

In the above described structure, when the level of an input signal is within a first level range for exceeding the first predetermined level, no voltage is applied to the first terminal 16 and the second terminal 28, but both are caused to be in a released state. Then, both the first and second switching diodes 5 and 6 first become off, and since no voltage is applied to the gate of the first FET 4 either, no drain current flows through the first FET 4, which is out of the operating state.

On the other hand, since both the gate and source of the second FET 22 are at the same potential as that at the ground, the gate voltage becomes higher than the pinch off voltage with respect to the source, and the connection between drain and source of the second FET 22 turns on.

Therefore, the input signal bypasses the amplifier 3 and is outputted to the output end 2 by way of the by-pass circuit 21.

When the level of the input signal is within the second level range which is equal to or lower than the first predetermined level and is equal to or higher than the second predetermined level, the first voltage is applied to the first terminal 16. Then, the first and second switching diodes 5 and 6 conduct, and the first bias voltage is applied to the gate of the first FET 4 to enter an operating state in which amplification can be performed. This bias voltage is set by the first feeding resistance 14 and the first bias resistance 9.

On the other hand, at this time, second voltage is applied to the second terminal 28. The second voltage is set to voltage (about 5 volt) higher than voltage obtained by adding the pinch off voltage (about 4 volt) of the second FET 22 to the forward voltage (about 0.7 volt) of the diode 23. Then, the gate voltage becomes equal to or lower than the pinch off voltage with respect to the source voltage, and therefore, the connection between drain and source of the second FET 22 becomes off.

As a result, the input signal does not pass through the by-pass circuit 21, but is amplified by the amplifier 3 to be outputted to the output end 2.

Next, when the level of the input signal is within the third level range being equal to or lower than the second predetermined level, third voltage is applied to the first terminal 16. The third voltage is set higher than the first voltage. Then, the first and second switching diodes 5 and 6 conduct, and the second bias voltage is applied to the gate of the first FET 4 to enter an operating state in which amplification can be performed. This bias voltage becomes higher than the first bias voltage, and therefore, the drain current further increases so that the gain of the first FET 4 becomes larger than that within the second level range.

On the other hand, at this time, second voltage is applied to the second terminal 28. Then, the gate voltage becomes equal to or lower than the pinch off voltage with respect to the source voltage, and therefore, the connection between drain and source of the second FET 22 becomes off.

As a result, the input signal does not pass through the by-pass circuit 21, but is amplified by the amplifier 3 to be outputted to the output end 2.

Therefore, relationship of the range of output signal level (R) with respect to the range of input signal level can be narrowed to about one-third as shown in Fig. 2, which exhibits a significant effect to improvement of distortion and NF.

In this respect, if the third voltage is set to the same magnitude as the second voltage, and values for the first and second resistance for divided voltage 31 and 32 are set in advance such that divided voltage at the first terminal 16 when the second voltage is applied to the second terminal 28 is equal to the first voltage, the second voltage can be applied only to the second terminal 28 when the input signal level is within the second level range. Therefore, if the application of the second voltage is assumed to be H, both the first terminal 16 and the second terminal 28 can be released when the input signal level is within the first level range, the first terminal 16 can be released and the second terminal can be set to H when within the second level range, and the first terminal 16 can be set to H, and the second terminal 28 can be set to H when within the third level range. Thus, voltage to be applied can be made into one type.

If a decoder having two output terminals is provided, voltage at a high level H being second voltage, and voltage at a low level L to be released are caused to be outputted from two output terminals depending upon the range of the input signal level, and these terminals are connected to the first terminal 16 and the second terminal 28 in advance, the transmission path switching circuit will be able to be automatically switched in response to the range of the input signal level.

### [Effect of the Invention]

As described above, according to the present invention, in a transmission path switching circuit provided with an amplifier and a by-pass circuit, and constructed so as to switch the gain in the amplifier between two stages, when the level of an input signal inputted to the input end is within the first level range being equal to or higher than the first predetermined level, the input signal is outputted to the output end through the by-pass circuit; when within the second level range being lower than the first predetermined level and equal to or higher than the second predetermined level, the gain of the amplifier is set to the first gain; and when within the third level range being equal to or lower than the second predetermined level, the gain of the amplifier is set to a second gain being higher than the first gain. Therefore, the relationship of the range of output signal level (R) with respect to the range of input signal level can be narrowed into about one-third, which exhibits a significant effect to improvement of distortion and NF.

Also, in a transmission path switching circuit according to the present invention, the amplifier has the first FET, a first switching diode, and a second switching diode, and the by-pass circuit has a second FET; when the level of the input signal is within the first level range, the first and second switching diodes are turned off, and the gate voltage of the second FET is made higher than the pitch off voltage; when the level of the input signal is within the second level range, the gate voltage of the second FET is made lower than the pinch off voltage, the first and second switching diodes are turned on, and the first bias voltage is applied to the gate of the first FET; and when the input signal is within the third level range, the gate voltage of the second FET is made lower than the pinch off voltage, the first and second switching diodes are turned on, and second bias voltage being higher than the first bias voltage, is applied to the gate of the first FET. Therefore, the input signal can be caused to pass through the by-pass circuit within the first level range, and the gain of the amplifier can be changed within the second level range and the third level range.

Also, in a transmission path switching circuit according to the present invention, when the level of the input signal is within the first level range, no voltage is applied to a first terminal for applying voltage to the anode of the first switching diode, the gate of the first FET, and the anode of the second switching diode, and a second terminal for applying voltage to the gate and source of the second FET to cause both terminals to be in a released state; and when the level of the input signal is within the second level range, the first voltage is applied to the first terminal, second voltage, which becomes equal to or higher than a sum of forward voltage of the diode for voltage drop and the pinch off voltage, is applied to the second terminal; and when the level of the input signal is within the third level range, third voltage being higher than the first voltage, is applied to the first terminal, and the second voltage is applied to the second terminal. Therefore, it becomes easier to switch between the amplifier and the by-pass circuit, and to switch the gain in the amplifier.

In the transmission path switching circuit according to the present invention, the anode of the first switching diode is connected to the gate of the first FET in a DC way, the cathode thereof is grounded through the first bias resistance, the cathode of the second switching diode is grounded through the second bias resistance, the anode of the first switching diode is connected to the first terminal through first feeding resistance, and the anode of the second switching diode is connected to the first terminal through the second feeding resistance. Therefore, it is easy to set bias voltage in the gate of the first FET.

In the transmission path switching circuit according to the present invention, the first terminal is grounded through first resistance for divided voltage, second resistance for divided voltage is connected between the first terminal and the second terminal, the third voltage is made equal to the second voltage, values for the first and second resistance are set such that the divided voltage at the first terminal when the second voltage is applied to the second terminal becomes equal to the first voltage, when the level of the input signal is within the second level range, the second voltage is applied to only the second terminal, and when the level of the input signal is within the third level range, the second voltage is applied to the first terminal and the second terminal. Therefore, it is possible to switch between the amplifier and the by-pass circuit and to switch the gain in the amplifier by the use of one type of the second voltage.

## Claims

1. A transmission path switching circuit, comprising an amplifier disposed between an input end and an output end, and a by-pass circuit disposed between the input end and the output end, and constructed so as to switch gain in the amplifier between two stages, wherein when a level of an input signal inputted to the input end is within a first level range being equal to or higher than a first predetermined level, the input signal is not amplified but is outputted to the output end through the by-pass circuit; wherein when equal to or lower than the first predetermined level, the input signal is amplified by the amplifier to output to the output end; wherein when the level of the input signal is within a second level range between the first predetermined level and a second predetermined level being lower than the first predetermined level, gain of the amplifier is set to first gain; and wherein when the input signal is within a third level range being equal to or lower than the second predetermined level, the gain of the amplifier is set to second gain being higher than the first gain.

2. A transmission path switching circuit according to Claim 1, wherein the amplifier has a first FET, a first switching diode disposed in series between the input end and the gate of the first FET, and a second switching diode disposed in series between a drain of the first FET and the output end, and the by-pass circuit has a second FET, to whose input end one of drain and source is connected, and to whose output end the other is connected; wherein when the level of the input signal is within the first level range, the first and second switching diodes are turned off, and gate voltage of the second FET is made higher than pinch off voltage of the second FET; wherein when the level of the input signal is within the second level range, the gate voltage of the second FET is made lower than the pinch off voltage, the first and second switching diodes are turned on, and first bias voltage is applied to the gate of the first FET; and wherein when the input signal is within the third level range, the gate voltage of the second FET is made lower than the pinch off voltage, the first and second switching diodes are turned on, and second bias voltage being higher than the first bias voltage, is applied to the gate of the first FET.

3. A transmission path switching circuit according to Claim 2, provided with a first terminal for applying voltage to an anode of the first switching diode, the gate of the first FET, and the anode of the second switching diode; a second terminal for applying voltage to the gate and source of the second FET through feeding resistance respectively; and a diode for voltage drop, whose anode is connected to the gate of the second FET, and whose cathode is grounded, wherein when the level of the input signal is within the first level range, no voltage is applied to the first terminal and the second terminal, but the both terminals are caused to be in a released state; wherein when the level of the input signal is within the second level range, first voltage is applied to the first terminal, and second voltage, which becomes equal to or higher than a sum of forward voltage of the diode for voltage drop and the pinch off voltage, is applied to the second terminal; and wherein when the level of the input signal is within the third level range, third voltage being higher than the first voltage, is applied to the first terminal, and the second voltage is applied to the second terminal.

4. A transmission path switching circuit according to Claim 3, wherein the anode of the first switching diode is connected to the gate of the first FET in a DC way, and the cathode thereof is grounded through first bias resistance; wherein the cathode of the second switching diode is grounded through second bias resistance; and wherein the anode of the first switching diode is connected to the first terminal through first feeding resistance, and the anode of the second switching diode is connected to the first terminal through second feeding resistance.

5. A transmission path switching circuit according to Claim 3 or 4, wherein the first terminal is grounded through first resistance for divided voltage, second resistance for divided voltage is connected between the first terminal and the second terminal, the third voltage is made equal to the second voltage; wherein values for the first and second resistance are set such that divided voltage at the first terminal when the second voltage is applied to the second terminal becomes equal to the first voltage; wherein when the level of the input signal is within the second level range, the second voltage is applied only to the second terminal; and wherein when the level of the input signal is within the third level range, the second voltage is applied to the first terminal and the second terminal.
